# EUROPÄISCHE PATENTANMELDUNG

(11) **EP 0 739 157 A2**
(43) Veröffentlichungstag der Anmeldung: **23.10.1996**
(21) Anmeldenummer: 96105957.3
(22) Anmeldetag: 16.04.1996
(51) Int. Cl.: H05K 7/18, H01R 9/26

(54) **Einrichtung zum Anschluss externer Leitungen an ein Automatisierungsgerät**

(30) Priorität: 19.04.1995 DE 29506629 U
(71) Anmelder: SIEMENS AKTIENGESELLSCHAFT, 80333 München (DE)
(72) Erfinder: Roster, Thomas, 76275 Ettlingen (DE); Schmitt, Reinhard, 76829 Landau (DE)

(57) **Zusammenfassung**

Die Erfindung betrifft eine Einrichtung zum Anschluß externer Leitungen an ein Automatisierungsgerät, insbesondere in einem Schrank der Automatisierungstechnik, mit Anschlußmodulen (2), die mit in einem Gehäuse angeordneten elektrischen Leitern versehen sind, deren an gegenüberliegenden Stirnseiten des Moduls (2) austretende Endabschnitte als Anschlußelemente für Verdrahtungen ausgebildet sind, und mit einem flachen Trägerblech (1), an dessen einer Seite die Anschlußmodule (2) befestigt sind und das rechtwinklig abgebogene, gelochte Laschen (3, 4) zur waagerechten Montage in einem Standard-19''-Aufbausystem aufweist. Die Einrichtung kann zusätzlich mit zwei Kabelkanälen (9, 10) versehen werden. Durch die erfindungsgemäße Einrichtung wird eine hohe Anzahl Anschlußelemente je Höheneinheit im 19''-Aufbausystem erreicht.

Die Erfindung wird angewandt in Elektronikschränken.

## Beschreibung

Die Erfindung betrifft eine Einrichtung zum Anschluß externer Leitungen an ein Automatisierungsgerät, insbesondere in einem Schrank der Automatisierungstechnik, nach dem Oberbegriff des Anspruchs 1.

Die Funktionsdichte auf Flachbaugruppen der Automatisierungs- oder Prozeßleitsysteme nimmt ständig zu und damit auch die Anzahl der Anschlußstellen für Prozeßein- oder -ausgänge je Flachbaugruppe. Die Zuordnung der peripheren Leitungen, die ein- oder ausgehende Prozeßsignale führen, zu den einzelnen Anschlußstellen der Flachbaugruppen wird in derselben Verpackungseinheit, in der auch ein oder mehrere Automatisierungsgeräte untergebracht sind, durch eine Rangierung realisiert. Aus dem DE-GM 94 01 114 ist dazu ein Anschlußmodul bekannt, das in einem Gehäuse reihenförmig angeordnete elektrische Leiter aufweist, deren an gegenüberliegenden Stirnseiten des Moduls austretende Endabschnitte als Anschlußelemente für Verdrahtungen ausgebildet sind. An der Vorderseite beispielsweise eines Schrankes der Automatisierungstechnik werden die externen Leitungen auf den vorderen Endabschnitten der elektrischen Leiter aufgelegt. Diese leiten die Signale zur Rückseite weiter, auf der sie durch eine Verdrahtung zwischen den an der Rückseite austretenden Endabschnitten und den Anschlußstellen, die sich auf der Rückseite von Baugruppenträgern befinden, zur Auswertungselektronik auf den Flachbaugruppen geführt werden.

Der Erfindung liegt die Aufgabe zugrunde, die bekannte Einrichtung zum Anschluß externer Leitungen an ein Automatisierungsgerät derart weiterzubilden, daß sie bei geringem Raumbedarf eine einfache Zuführung und Rangierung externer Leitungen ermöglicht.

Zur Lösung dieser Aufgabe weist die neue Einrichtung zum Anschluß externer Leitungen der eingangs genannten Art das im kennzeichnenden Teil des Anspruchs 1 genannte Merkmal auf. In den Unteransprüchen sind vorteilhafte Weiterbildungen der Erfindung beschrieben.

Die Erfindung hat den Vorteil, daß sie eine hohe Dichte der Anschlußelemente je Volumeneinheit ermöglicht. Bei einem Schrank der Automatisierungstechnik wird dadurch ein hoher Nutzungsgrad und ein ausgewogenes Verhältnis zwischen im Schrank eingebauter Elektronik und Anzahl der Anschlußelemente für externe Leitungen erreicht. In einem 19''-Aufbausystem ist der Einbau einer erfindungsgemäßen Einrichtung zum Anschluß externer Leitungen sowohl oberhalb als auch unterhalb eines Automatisierungsgeräts möglich. Die Anschlußmodule sind einzeln nachrüst- und austauschbar. Durch den Aufbau der gesamten Einrichtung wird eine kostengünstige Realisierung erreicht. Das Trägerblech kann in einfacher Weise eingebaut werden. Dadurch werden Montagezeiten verkürzt.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:

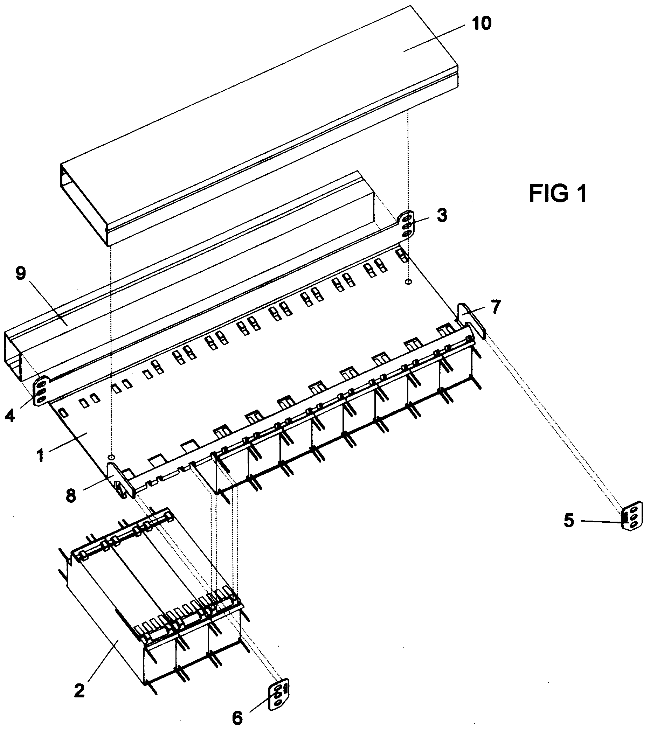

- Figur 1: eine Explosionsdarstellung einer Einrichtung zum Anschluß externer Leitungen,
- Figur 2: eine Frontansicht und
- Figur 3: eine Rückansicht einer in einem 19''-Aufbausystem eingebauten erfindungsgemäßen Einrichtung.

Eine Einrichtung zum Anschluß externer Leitungen an ein Automatisierungsgerät besteht im wesentlichen aus einem flachen Trägerblech 1 und Anschlußmodulen 2. Die Anschlußmodule 2 können an der einen Seite des Trägerblechs 1, in diesem Ausführungsbeispiel an dessen Unterseite, angebracht werden. Die Befestigung der Anschlußmodule 2 erfolgt über je vier Haken, die an der Oberseite des Gehäuses im Bereich der Ecken angeordnet sind. Diese werden in entsprechend vorgestanzte Löcher in dem dünnwandigen Trägerblech eingehängt. Zur Verriegelung dienen Federzungen, die in ebenfalls vorgestanzte Löcher einrasten. Bezüglich weiterer Einzelheiten der Anschlußmodule 2 wird auf das in der Beschreibungseinleitung bereits erwähnte DE-GM 94 01 114 verwiesen. Die Maße des Trägerblechs 1 sind so festgelegt, daß es waagerecht in Standard-19''-Aufbausystemen einbaubar ist. Zur Befestigung besitzt das Trägerblech 1 an seiner Rückseite rechtwinklig abgebogene, gelochte Laschen 3 und 4, mit denen es an einer Standard-Lochreihe des 19''-Aufbausystems angeschraubt werden kann. Weiterhin sind gelochte Bleche 5 und 6 vorhanden, die bei erhöhter Schwingungsbeanspruchung der Aufbautechnik verwendet werden können. Sie werden über rechtwinklig abgebogene Laschen 7 bzw. 8 des Trägerblechs 1 geschoben und an den vorderen Standard-Lochreihen des 19''-Aufbausystems angeschraubt. Durch die gewählte Form der Laschen 7 und 8 kann sich der Abstand der hinteren und vorderen Standard-Lochreihen in einem großen Toleranzfeld bewegen. Das Trägerblech 1 ist somit mit seinen vier Ecken im 19''-Aufbausystem schwingungsfest gelagert. Zur besseren Übersichtlichkeit sind in den Zeichnungen nur vier Anschlußelemente je Anschlußmodul 2 dargestellt, obwohl diese tatsächlich 64 Anschlußelemente aufweisen. Das Trägerblech 1 erlaubt aufgrund seiner Abmessungen und seines Lochbildes das Einhängen von 11 Anschlußmodulen 2. Damit ergeben sich 11 x 64 = 704 Anschlußstellen für externe Leitungen. Da die Anschlußelemente auf der hinteren Stirnseite des Anschlußmoduls 2 in einem engeren Rasterabstand angeordnet sind als die Anschlußelemente auf der vorderen Stirnseite, verbleibt oberhalb der Anschlußelemente der hinteren Stirnseite genügend Freiraum, um im hinteren Bereich der Einrichtung zum Anschluß externer Leitungen einen Kabelkanal 9 unterzubringen. Dieser Kabelkanal 9 dient zur Aufnahme von Wrap-Leitungen, die an die Anschlußelemente der hinteren Stirnseite, die als Wrap-Pfosten mit den Abmessungen 1 mm x 1 mm ausgebildet sind, angeschlagen werden. Die Wrap-Leitungen verlassen seitlich den Kabelkanal und werden zu den entsprechenden Anschlußstellen für Ein- oder Ausgänge der Flachbaugruppen verdrahtet. Auf der Oberseite des Trägerblechs 1 ist ein Kabelkanal 10 befestigbar, in dem externe Leitungen verlegt werden. Durch eine seitliche Öffnung im Längsholm des 19''-Aufbausystems werden diese in den Kabelkanal 10 eingeführt und auf der Vorderseite der erfindungsgemäßen Einrichtung auf ein Anschlußelement eines Anschlußmoduls 2 mit den Abmessungen 0,8 mm x 2,4 mm aufgelegt. Damit ist eine einfache und übersichtliche Zuführung externer Leitungen möglich.

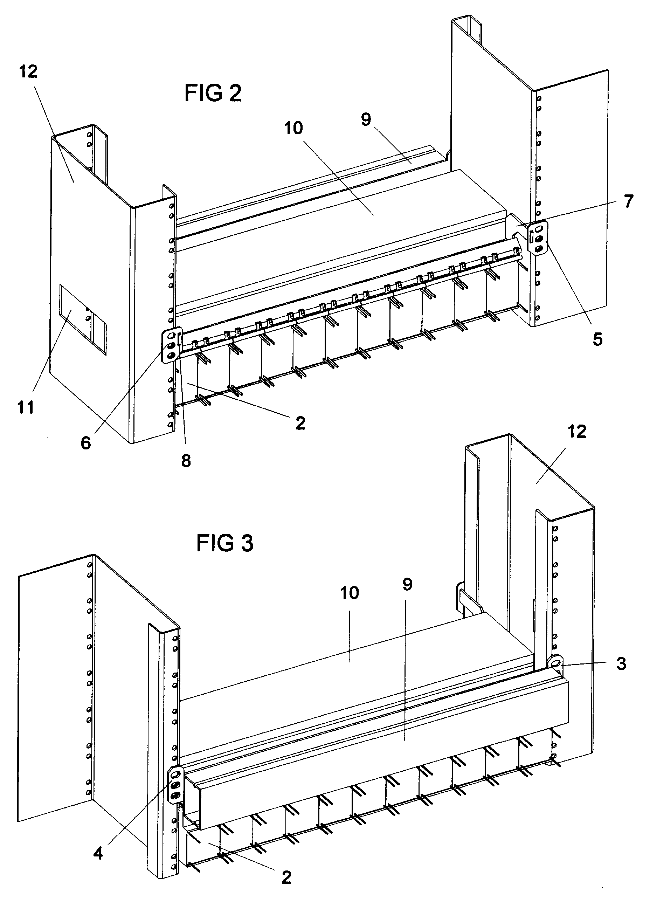

Bei der eingebauten Einrichtung zum Anschluß externer Leitungen nach Figur 2 sind gleiche Teile mit gleichen Bezugszeichen versehen. In Figur 2 ist eine seitliche Öffnung 11 im linken Längsholm 12 eines 19''-Aufbausystems, durch welche externe Leitungen in den Kabelkanal 10 eingeführt werden können, gut sichtbar. Weiterhin zeigt Figur 2, wie die seitlichen Laschen 7 und 8 im eingebauten Zustand der Einrichtung in Schlitze der gelochten Bleche 5 bzw. 6 eingreifen, so daß die gesamte Einrichtung lagestabil gehalten wird. Der erfindungsgemäße Aufbau der Einrichtung erlaubt den Einbau in einem sehr geringen Höhenraum des 19''-Aufbausystems. Insbesondere in Schränken der Automatisierungstechnik ist dies von Vorteil.

In der Rückansicht gemäß Figur 3 werden wiederum dieselben Bezugszeichen für die bereits beschriebenen Teile der Einrichtung verwendet. Aufgrund des engeren Abstands der Anschlußelemente auf der hinteren Stirnseite der Anschlußmodule 2 kann der Kabelkanal 9 derart eingebaut werden, daß er die Rückseite der Anschlußmodule 2 teilweise verdeckt. Dadurch wird eine verbesserte Raumnutzung erreicht.

## Patentansprüche

1. Einrichtung zum Anschluß externer Leitungen an ein Automatisierungsgerät, insbesondere in einem Schrank der Automatisierungstechnik,
- mit Anschlußmodulen (2), die mit in einem Gehäuse angeordneten elektrischen Leitern versehen sind, deren an gegenüberliegenden Stirnseiten des Moduls (2) austretende Endabschnitte als Anschlußelemente für Verdrahtungen ausgebildet sind, und
- mit einem dünnwandigen Träger, an welchem die Anschlußmodule (2) befestigt sind,
**dadurch gekennzeichnet,**
- daß der dünnwandige Träger durch ein im wesentlichen flaches Trägerblech (1) gebildet wird, an dessen einer Seite die Anschlußmodule (2) befestigt sind und das rechtwinklig abgebogene, gelochte Laschen (3, 4) zur waagerechten Montage in einem Standard-19''-Aufbausystem aufweist.

2. Einrichtung nach Anspruch 1, **dadurch gekennzeichnet,**
- daß die Laschen (3, 4) derart am Trägerblech (1) angeordnet sind, daß sie zur Montage in einem 19''-Aufbausystem leicht zugänglich an dessen Rückseite befestigbar sind.

3. Einrichtung nach Anspruch 2, **dadurch gekennzeichnet,**
- daß weiterhin gelochte Bleche (5, 6) vorhanden sind, die vorne an Längsholmen des 19''-Aufbausystems befestigbar und mit einer Ausnehmung derart versehen sind, daß das Trägerblech (1) zur Halterung an seiner Vorderseite in die Ausnehmung im wesentlichen waagerecht einschiebbar ist und sich der Abstand der hinteren und vorderen Standard-Lochreihe des 19''-Aufbausystems in einem großen Toleranzfeld bewegen kann.

4. Einrichtung nach einem der vorhergehenden Ansprüche, **dadurch gekennzeichnet,**
- daß auf der anderen Seite des Trägerblechs (1) ein querverlaufender Kabelkanal (10) zur Aufnahme externer Leitungen angeordnet ist, die seitlich in den Kabelkanal (10) einführbar und an seiner Vorderseite zum Anschluß an den vorderen Anschlußelementen der Anschlußmodule (2) herausführbar sind.

5. Einrichtung nach einem der vorhergehenden Ansprüche, **dadurch gekennzeichnet,**
- daß an der hinteren Seite des Trägerblechs (1) ein querverlaufender Kabelkanal (9) zur Aufnahme von Wrap-Leitungen angeordnet ist, die zur Verbindung der hinteren Anschlußelemente der Anschlußmodule (2) mit Anschlußstellen des Automatisierungsgeräts dienen.
